# EUROPEAN PATENT APPLICATION

(11) **EP 1 962 069 A1**
(43) Date of publication of application: **27.08.2008**
(21) Application number: 07102961.5
(22) Date of filing: 23.02.2007
(51) Int. Cl.: G01J 11/00, G01M 11/00

(54) **Polarization controlled interferometric chirp characterization**

(71) Applicant: Agilent Technologies, Inc., Santa Clara CA 95051 (US)
(72) Inventor: Maestle, Ruediger, 71032 Boeblingen (DE)
(74) Representative: Barth, Daniel Mathias

(57) **Abstract**

The invention relates to determining a chirp property (chirp(t)) of an optical device (1), comprising: receiving an input optical signal (S1) from the optical device (1) and generating an output optical signal (S4) by providing a change of a state of polarization by means of a polarization controller operating at a first setting and an interferometric superposition of two signal parts in any order, determining an optical intensity (PA(t), PB(t), PC(t) P_{out.1}(t), P_{out.2}(t), P_{out.3}(t), P_{out.4}(t)) of the output optical signal (S4), controlling the polarization controller (21) to operate at a second setting in order to provide a different change of the state of polarization and repeating previous steps for determining a corresponding optical intensity, and determining the chirp property by evaluating the optical intensities (PA(t), PB(t), PC(t) P_{out.1}(t), P_{out.2}(t), P_{out.3}(t), P_{out.4}(t)) determined in response to the different polarization controller settings.

## Description

### BACKGROUND ART

The present invention relates to determining a chirp characteristic of an optical device.

For determining optical properties of an optical device, interferometric measurements are often performed. Therefore, in principle, light is split into two branches, wherein the two branches have different optical path lengths. At the end of both branches, the light is recombined. The recombined light shows an interference pattern that varies depending on the wavelength.

One important optical property determination using frequency discrimination by means of an interferometer, e.g. a so-called Mach-Zehnder Interferometer is a determination of a chirp. Thereto, an optical transmitter might be coupled to a Mach-Zehnder Interferometer -MZI- working as a frequency discriminator. The differential delay between the two paths creates sinusoidal amplitude versus frequency dependence, therewith converting frequency deviations into amplitude variation. The frequency spacing between two maximum transmission points is called the free spectral range (FSR). The MZI is tuned to different working points with respect to the center frequency of the signal to measure chirp signals. The transmitted power of each the interferometer output signals are detected as a function of the time. The chirp is determined by setting in relation the power or intensity functions and known interferometer parameters. Such methods are e.g. described in the article "Making Time-Resolved Chirp Measurements Using the Optical Spectrum Analyzer and Digital Communications Analyzer", Application Note 1550-7 of the same applicant Agilent Technologies Inc. being available from web pages of the applicant, or in the document "A New Method for Measuring Time-Resolved Frequency Chirp of High Bit Rate Sources" of Christian Laverdière et al., published in IEEE Photonics Technology Letters, Vol. 15, No.3, March 2003.

### DISCLOSURE

It is an object of the invention to provide an improved determination of a chirp characteristic. The object is solved by the independent claims. Further embodiments are shown by the dependent claims.

For optical communications, a light source, e.g. a laser source, is modulated in order to transmit digital information. Thereto the light source might be amplitude-modulated according to a digital signal being received from a digital signal source. An important parameter of the optical signal or the optical transmitter respectively, relates to high frequency phase variations, also being referred to as frequency chirp or as chirp.

According to embodiments of the invention, an optical test apparatus for determining a chirp characteristic of an optical transmitter, the optical transmitter also being referred to as device under test -DUT-, is provided comprising a tunable frequency-to-amplitude conversion circuit for receiving an input optical signal from the optical device and providing an output optical signal, thereby translating optical frequency variations over time of the input optical signal into intensity variations over time of the output optical. The frequency-to-amplitude conversion circuit is tunable to different operating points, whereby each working point relates to a certain mean amplitude of its output in response to a mean frequency of its input. The frequency-to-amplitude conversion circuit is set to plurality of different operating points and for the plurality of settings a corresponding plurality of output signals is generated. An optical detector, by providing an opto-electrical conversion of the output signals, generates corresponding power signals indicative of the actual intensity or power of the output signals. An analyzing circuit evaluates the power signals in conjunction with known parameters of frequency-to-amplitude conversion circuit and/or of the DUT, and determines the chirp characteristic therefrom.

The tunable frequency-to-amplitude conversion circuit comprises a dual path device comprising a first and a second optical path having different optical path lengths to each other for providing an interferometric superposition, and a polarization controller for providing the different working point settings by varying a state of polarization -SOP- change of the light traveling through, wherein the dual path device and the polarization controller are optically connected in series.

The polarization controller might for example comprise a quarter-wave plate and a half-wave plate positioned in series. For generating arbitrary polarization changes between the input SOP and the output SOP, both plates are individually tunable. For example, the quarter-wave plate and the half-wave plate are realized as being rotatable around a propagation axis of the light traveling through. The plates are each rotated by a determined angle in order to achieve a certain output SOP state. The polarization controller further might comprise a rotatable polarizer to exactly adjust the input SOP to the waveplates plates. Such Polarization controller is e.g. available fro the applicant, such as the Agilent 8169A Polarization Controller. Information about the Agilent 8169A Polarization Controller can be drawn from the technical specifications available at Product or Service Web Pages of the applicant.

The dual path device provides a differential delay to different components of the received light. Thereto, the dual path device is arranged to polarization-dependent split the received light into two, preferably equal fractions, thereby guiding the first light fraction having a first SOP over a first optical path and the second optical fraction having a second SOP over a second optical path. The first and second optical path have different optical path lengths, whereby the optical path length is the product of the geometric length of the light path, and the index of refraction of the light pass medium.

The difference in optical path length between the two paths corresponds to a so-called free spectral range -FSR- of the dual path device. The FSR is preferably set such that a good conversion efficiency from frequency variations to amplitude variations is achieved. This means the FSR has to be adapted to the expected chirp signals.

In an embodiment, dual path device comprises two spatially separated optical paths constituted by a first polarization beam splitter splitting the received light into the two path having different optical path lengths and a second polarization beam splitter for combining the light traveling over both paths. The different path lengths might be realized by guiding one path directly from the first to the second polarization beam splitter and the other path over an arrangement of mirrors from the first to the second polarization beam splitter. The mirror arrangement might be arranged to be movable with respect to the polarization beam splitters so that the FRS is tuned by moving the mirror arrangement.

Alternatively, the dual path device might be realized by means of a polarization maintaining fiber (PMF), wherein the first and the second optical path represent the principal optical axes of the polarization maintaining fiber.

Differently to prior art solution as mentioned above, the dual path device might only be set in advance to a measurement cycle in order to adapt the FSR to the input optical signal for the case that the FSR is not already adapted, whereby the change of the operation points during a measurement cycle are performed by tuning the polarization controller. Thus the tuning element is separated from the dual path element generating the path length differences. This allows employing a simple and optically and mechanically stable dual path element. One dual path element can be easily exchanged by another one for adapting the test apparatus to any DUT.

Each SOP set by the polarization controller can be regarded as a vector in a Stokes space. The endpoints of these vectors, further also referred to as SOP system, span a geometric shape. Depending on the number of endpoints (or settings respectively), the geometric shape is a line (two endpoints), a triangle (3 endpoints) or a polyhedron (more that three endpoints).

In an embodiment, the polarization controller is sequentially set to three points for converting the SOP to three states such that the mean intensity of a first output signal equals the mean intensity of the input signal and the mean intensity of a second and third output signal equally half the mean intensity of the input.

One problem of polarisation controlling is that while the wavelength of an input signal varies, the SOP system might not remain constant and significantly differ from an optimum geometric shape. According to embodiments of the inventions, a setting of the polarization controller is determined such that variations of the wavelength of the input signal result in only small variations of the shape of the polyhedron are kept small and mainly results in a rotation of the shape. With properly determined settings, e.g. angular positions of a quarter wave plate and a half wave plate the relative volume change of a regular tetrahedron spanned by four tetragonal SOP's might be kept below 10 % within the (significant) spectral range of the input signal. In the following, such SOP's will also be referred to as achromatic SOP's. Therefore the wavelength dependence of the polarization controller does not significantly affect the determination of chirp properties of the DUT

In an alternative embodiment with respect to the three-point measurement described above, the polarization controller is sequentially set to four achromatic SOP's. Preferably, the SOP's are chosen such that they span a regular tetrahedron, or in other words, the polarization controller is set to four tetragonal SOP's, and the chirp is determined based on four corresponding intensity measurements. This allows to significantly reduce the phase difference noise and thus to obtain significantly better results compared to a setting of orthogonal SOP's as used for three point measurements described above.

In an embodiment, a measurement setup is provided comprising a pattern generator that generates a repetitive digital pattern for modulating the optical transmitter. The output signal of the frequency-to-amplitude conversion circuit is detected by a fast optical detector that provides corresponding intensity functions to a sampling oscilloscope. Further, the pattern generator provides a trigger signal to the sampling oscilloscope so that the sampling oscilloscope is able to sample the output signals according to the repetition scheme.

In a further embodiment, a method of determining the chirp characteristic is provided comprising:
- generating an output optical signal in response to an input signal of the DUT by performing in any order: changing a SOP by means of a polarization controller operating at a first setting, and splitting into two partial signals and providing an interferometric superposition of both signals,
- at least controlling the polarization controller to operate at a second setting in order to provide a different change of the SOP and generating an output optical signal by performing a second time in any order: changing a SOP by means of a polarization controller operating at a second setting, and splitting into two partial signals and providing an interferometric superposition of both signals, and
- determining the chirp characteristic by evaluating the optical intensities of the output optical signals received in response to the different polarization controller settings.

Embodiments of the invention can be partly or entirely embodied or supported by one or more suitable software programs, which can be stored on or otherwise provided by any kind of data carrier, and which might be executed in or by any suitable data processing unit.

### BRIEF DESCRIPTION OF DRAWINGS

Other objects and many of the attendant advantages of embodiments of the present invention will be readily appreciated and become better understood by reference to the following more detailed description of embodiments in connection with the accompanied drawings. Features that are substantially or functionally equal or similar will be referred to by the same reference signs.

Fig. 1 shows a block diagram of an exemplary optical test setup for determining a chirp characteristic of an optical signal of an optical transmitter,

Fig. 2 shows a block diagram of an alternative frequency-to-amplitude conversion circuit of Fig.1,

Fig. 3 shows a block diagram of and alternative dual path device of Fig.1,

Fig. 4 shows a set of equations illustrating an exemplary chirp definition,

Fig. 5 shows a diagram illustrating an exemplary choice of first frequency-to-amplitude conversion circuit settings,

Fig. 6 shows exemplary first polarization controller settings corresponding to settings illustrated in Fig.5,

Fig. 7 shows a set equations illustrating a determination of chirp from measured power responses relating to the first polarization controller settings, and

Fig. 8 and Fig. 9 show sets of equations illustrating a determination of chirp from alternative polarization controller settings.

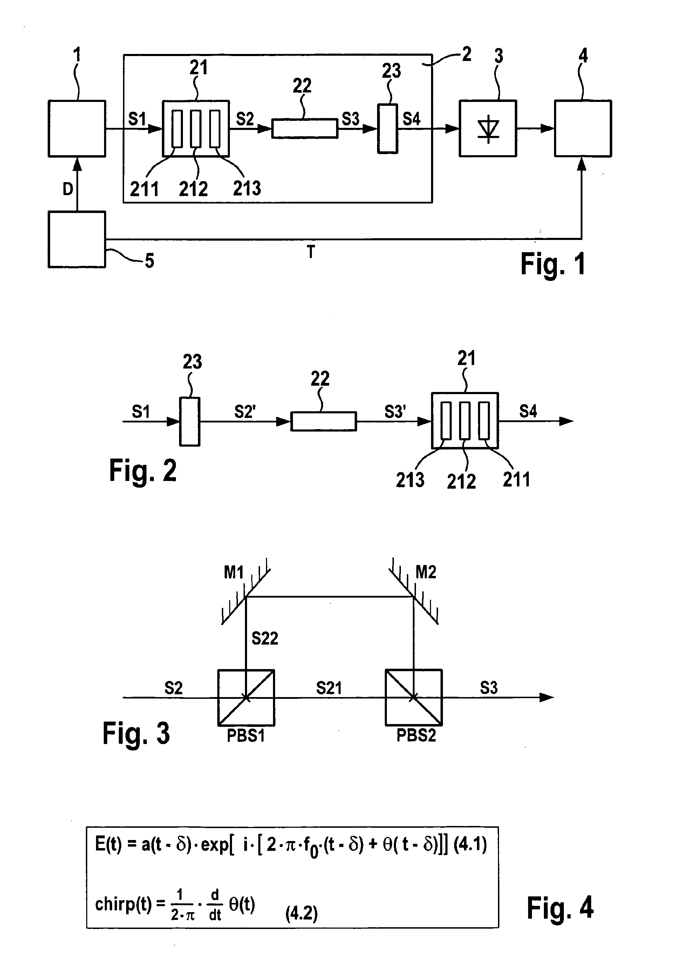

Fig. 1 shows a first setup for determining a chirp characteristic of an optical transmitter 1, in the following also being referred to as optical device under test -DUT-1. The test setup comprises an optical transmitter 1, also being referred to as optical device under test -DUT-, a tunable frequency-to-amplitude conversion circuit 2, an optical detector 3, an analyzing circuit 4 and a digital pattern generator 5. The optical transmitter 1 transmits an optical input signal S1 to the frequency-to-amplitude conversion circuit 2 that generates, in response to the input optical signal S1, a plurality of output optical signals S4 in dependence on a plurality of settings of the frequency-to-amplitude conversion circuit 2. The optical detector receives the output optical signals S4, provides an opto-electrical conversion of the output signals and generates corresponding electrical power signals P(t).The digital pattern generator 5 generates a repetitive digital test pattern and transmits a corresponding control signal D to the optical transmitter 1. The optical transmitter 1 comprises an optical modulator for digitally modulating a light generated by a light source, e.g. by a laser source, in response to the control signal D. The optical modulator might be an integral part of a laser source or might be a separate device optically connected in between the light source and the frequency-to-amplitude conversion circuit 2. The digital pattern generator 5 further generates a trigger signal T indicative of a timing of the digital test pattern and provides this signal to the analyzing circuit 4. The analyzing circuit 4 comprises a sampling circuit that samples the power signals P(t) in response to the trigger signal T and generates corresponding time-discrete digital power signals. The analyzing circuit 4 further comprises a processor that provides a digital processing to the sampled power signals and determines a chirp characteristic of the input optical signal S1.

The frequency-to-amplitude conversion circuit 2 comprises a polarization controller 21, a dual path device 22 and a polarizer 23 being optically connected in series.

The polarization controller 21 comprises a polarizer 211, a quarter-wave plate 212, and a half-wave plate 213 being positioned in series. The wave plates 212 and 213 are individually tunable in order to generate arbitrary polarization changes between an input and output polarization, i.e. the SOP of the input optical signal S1 and the SOP of a polarizer output optical signal S2. Preferably, the quarter-wave plate and the half-wave plate are realized being rotatable around a propagation axis of the light traveling through. The plates are each rotated by a determined angle in order to achieve a set output SOP state. The polarizer 211 might also be rotatable for exactly adjust the SOP of the input optical signal S1 to the waveplates plate axes.

The dual path device 22 comprises a first and a second optical path having different optical path lengths to each other for providing an interferometric superposition to an incident light. The dual path device 22 is arranged to polarization-dependent split the incident light into two preferably equal fractions, whereby a first light fraction having a first SOP is guided over the first optical path and the second optical fraction having a second SOP is guided over the second optical path. The first and second optical paths thereby provide each a different delay to the first and second fraction respectively. At the output of the device, the individually delayed fractions are recombined. The mean power of a corresponding recombined signal S3 is dependent on the difference in optical path length and the optical wavelength of the incident light S2. The distance (in frequency space) between adjacent transmission peaks is being referred to as free spectral range -FSR-. The FSR thus depends on the optical path length difference between the first and the optical second path. The FSR is preferably set such that a good conversion efficiency from frequency variations to amplitude variations is achieved. This means the FSR has to be adapted to the expected chirp signals.

The dual path device 22 can be realized by a polarization maintaining fiber - PMF-, wherein the principal optical axes (slow axis and fast axis) form the first and second optical path.

The recombined signal S3 is provided to a linear polarizer 23 that selects a certain linear component of state of polarization from this signal, thereby generating the output light S4 of the frequency-to-amplitude conversion circuit 2. The polarizer 23 is preferably aligned at 45° with respect to the main axis of the PMF (dual path device 22).

Fig. 2 shows a block diagram of an alternative frequency-to-amplitude conversion circuit of Fig.1. The alternative frequency-to-amplitude conversion circuit comprises the same devices, i.e. the polarization controller 21, the dual path device 22 and the polarizer 23, but arranged in opposite order with respect to the traveling signal. The input signal S1 is provided to the linear polarizer 23 that generates a linear polarized signal S2'. This signal is provided to the dual path device 22 that splits this light into two differently polarized fractions of preferably equal intensity. In the case that the dual path device 22 is realized by means of a PMF, the PMF is preferably arranged to receive the linear polarized signal S2'under an angle of 45 degree. The recombined signal S3' is the provided to the polarization controller 21 that is operated in opposite direction compared to Fig.1, i.e. the polarizer 211 and a half-wave plate 213 are permuted with respect to the signal propagation direction. Similar to the embodiment of Fig. 1, a plurality of output optical signals S4 are generated in response to a plurality of settings of the polarization controller 21.

Fig. 3 shows a block diagram of and alternative dual path device described under the previous figures. The alternative dual path device comprises two spatially separated optical paths constituted by a first polarization beam splitter PBS1 splitting the received light S2 into two fractions S21 and S22 and guiding them over two different paths having different optical path lengths. In the example shown here, the first polarization beam splitter PBS1 lets pass the first light fraction S21 having a first SOP straight to a second polarization beam splitter PBS2 and redirects the second light fraction S22 having a second SOP being orthogonal to the first SOP over a first and a second mirror M1 and M2 to the polarization beam splitter PBS2. The Second polarization beam splitter PBS2 recombines both light fractions S21 and S22 to the recombined signal S3.

The optical path length difference between the two path is dependent on a distance between the arrangement of the mirrors M1 an M2 and the arrangement of the polarization beam splitters PBS1 and PBS2. In an embodiment, the arrangement of the mirrors is realized to be movable with respect to the arrangement of polarization beam splitters in order to adjust the optical path length difference, and therewith to adjust the FSR of the dual path device.

Fig. 4 shows a set of equations illustrating an exemplary chirp definition. Thereto, formula 4.1 describes the optical field E(t) over the time of the modulated input signal S1 may with:

a(t) being the amplitude,

f₀ being the central frequency,

θ(t) being a phase term associated with chirp, and

δ being any time delay.

Formula 4.1 describes the chirp (t) over the time, wherein the chirp essentially is the derivation of the phase term θ(t) of the optical field E(t).

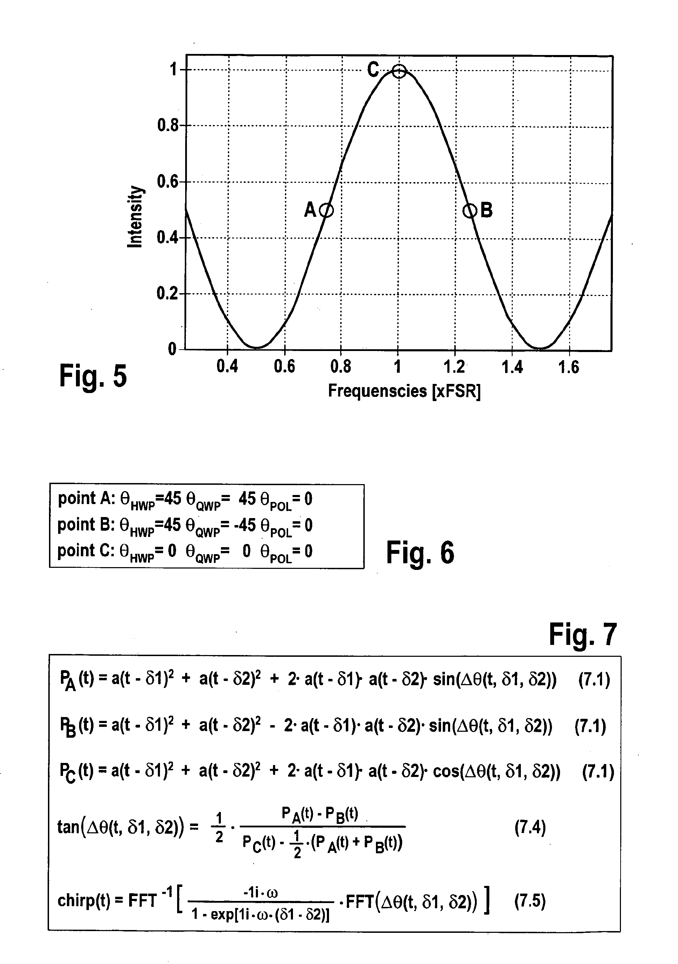

In an embodiment, the polarization controller 21 is sequentially set to three points for converting the SOP to three selected states. Fig 5 thereto shows a transmission curve of the frequency-to-amplitude conversion circuit 2 depicted as normalized intensity over the normalized frequency of the output signal S4. The normalized intensity is normalized to the maximum intensity, and the normalized frequency is normalized to the free spectral range FSR of the frequency-to amplitude conversion circuit 2.The choice of three selected Three points A, B C are marked at the curve, wherein the first point A relates to an FSR of 0.75 and an intensity of 0.5, point B relates to an FSR of 1.25 and an intensity of 0.5, And point C relates to an FSR of 1 and the maximum intensity 1.

Fig 6 shows exemplary settings of the polarization controller 21 in order set the frequency-to-amplitude conversion circuit 2 to the selected points A, B and C. Thereto, the half wave plate (HWP) 213, the quarter-wave plate (QWP) 212 and the polarizer (POL) are rotated to different pairs of angles (in degree) with respect to the main axis of the polarizer:

Point A: θ_{HWP}=45, θ_{QWP} =45

point B: θ_{HWP} =45, θ_{QWP} =-45

point C: θ_{HWP} =0, θ_{QWP} =0

and we get the power traces

Equations 7.1, 7.2 and 7.3 of Fig.7 show equations for the corresponding power responses P_{A}(t), P_{B}(t) and P_{C}(t) to be measured over the time, each as functions of the first delay time δ1 and δ2 of the different paths of the dual path circuit 22.

Equation 7.4 relates the phase difference Δθ with the measured power responses P_{A}(t), P_{B}(t) and P_{C}(t).

Equation 7.5 relates the desired chirp to the phase difference obtained from equation 7.4.

The above-described three point measurement method relates to a so-called orthogonal polarimetric determination of chirp.

By way of example, the dual path circuit 22 is realized as a polarization maintaining fiber PMF with an exemplary length of 2 m that shows a FSR about 300GHz. Such realization might e.g. be suited for signals at a data rate of 40 gigabit per second.

In an alternative embodiment with respect to the three-point measurement described above, the polarization controller is sequentially set to four SOP's. Preferably, the SOP's are chosen such that they span a regular tetrahedron, or in other words, the polarization controller is set to four tetragonal SOP's, and the chirp is determined on the base of four corresponding intensities. This allows to significantly reduce the phase difference noise and thus to obtain significantly better results compared to a setting of orthogonal SOP's as used for three point measurements described above.

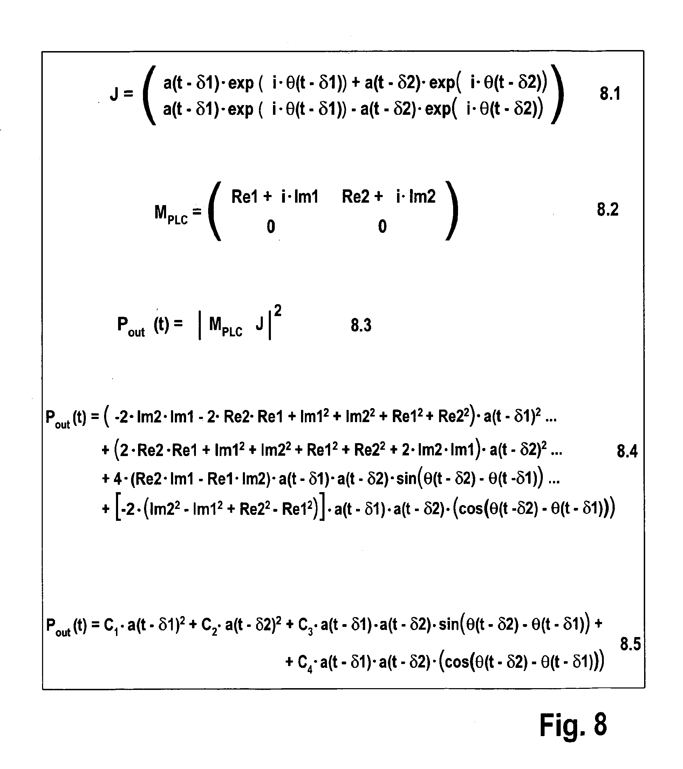

Thereto, Fig. 8 shows a set of equations generally relating the output power Pout (t) of the output signal S4 to an arbitrary setting of the polarization controller 21 and the delay times δ1 and δ2 of the different paths of the dual path circuit 22. By way of example, the following equations are based on the setup of Fig. 2, but as explained above, setups of Fig.1 and Fig.2 are equivalent and equations can be easily transformed between both setups. By way of example, the dual path circuit 22 is realized as a polarization maintaining fiber PMF. Considering a 45° degree launch of linear polarized light into the PMF the output Jones vector J is given by equation 8.1.

Equation.8.2 shows the general Jones Matrix M_{PLC} of the polarization controller 21 in reverse configuration, whereby the parameters Re1, Re2, Im1 and Im2 are arbitrary values depending on the setting of the polarization controller 21.

Equation 8.3 and 8.4 shows the power Pₒᵤₜ (t) of the output signal S4 by taking the square of the absolute value of the product of the Jones Matrix M_{PLC} and the Jones Matrix of equation 8.1. Equation 8.5 shows a short form of equation 8.4, wherein the terms comprising the parameters Re1, Re2, Im1 and Im2 are summarized as C1, C2, C3 and C4.

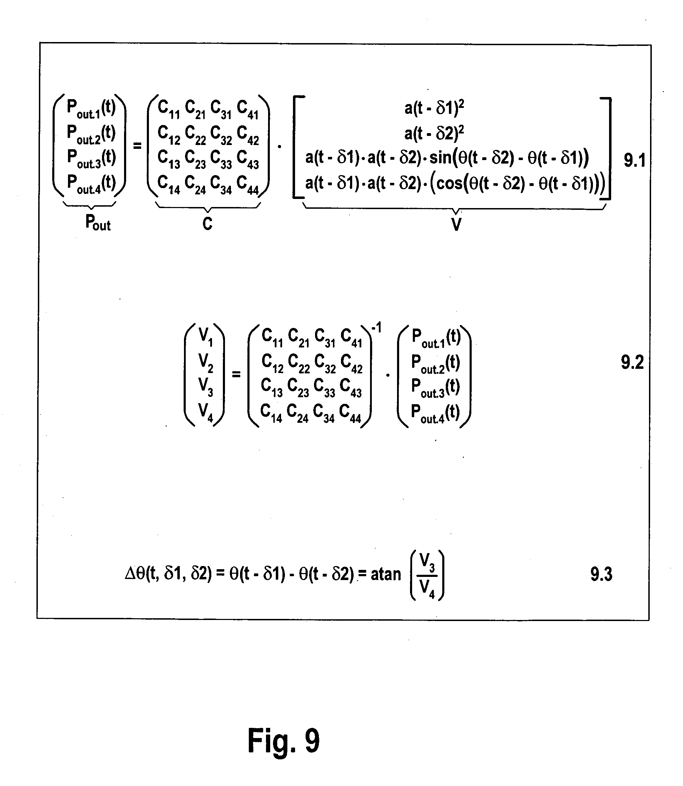

Fig. 9 shows a set of equations relating to the four point measurement based on general equation 8.5. This basically establishes a linear system of four equations (for three unknown values). Equation 9.1 shows a matrix equation relating a power vector Pₒᵤₜ comprising four measured power functions P_{out.1}(t) - P_{out.4}(t) to a product of a known 4x4 matrix C with an unknown vector V comprising desired values. The 4x4 matrix C comprises16 known parameters C₁₁ -C₄₄ being dependent on the four settings of the polarization controller 21. Equation is rewritten to Equation 9.2 relating the desired vector V to the inverted matrix C and the known power vector Pₒᵤₜ.

Equation 9.3 shows the desired phase difference Δθ as arctangent of the ratio of V3 and V4 of Equation 9.2, which can e.g. be de-convoluted by Fourier methods.

One problem of polarisation controlling is that depending on the settings of the polarization controller, different wavelength will encounter different changes of SOP; in other words, the SOP system generated by the polarization controller shows a wavelength dependency, whereby the wavelength dependency might be dependent on specific settings. As the input signal S2 shows a certain wavelengths spectrum due to the modulation, different wavelengths will encounter different SOP changes. In order to minimize the wavelength dependency of the polarization controlling, according to embodiments of the inventions, settings of the waveplates 212 and 213 of the polarization controller 21 are determined such that for different wavelength fractions of the input signal S2, relative variations of the shape of the SOP system constituted by the chosen settings are kept small or in other words that variations of the relative orientations of the Stokes vectors to each other do not significantly change. With properly determined settings, the relative volume change of a regular tetrahedron spanned by four tetragonal SOP's might be kept below +/- 5 % within a wavelength range between 1250 nm and 1650 nm thus enabling measurements over wide wavelength ranges with minimized errors. Therewith, the remaining wavelength dependency of the polarization controller does not significantly affect the chirp measurements.

The three point polarimetric chirp setup has shown about 5-8dB more output power compared to the filter method as described in the introduction. Consequently, due to the lower noise level, less measurement time is required.

The four point tetragonal detection is expected to further give significantly lower phase difference noise compared to the three point orthogonal detection. This results in significant improvement of chirp determination accuracy.

## Claims

1. An optical test apparatus for determining a chirp characteristic of a signal received from an optical device, comprising:
- a tunable frequency-to-amplitude conversion circuit (2) adapted for receiving an input optical signal (S1) from the optical device (1) and generating a set of output optical signals (S4), whereby the intensity (PA(t), PB(t), PC(t)) of each of the set of output optical signals (S4) is dependent of the frequency of the input optical signal (S1) in conjunction with a setting of the tunable frequency-to-amplitude conversion circuit (2),
- an optical detector (3) for determining optical intensities (PA(t), PB(t), PC(t) P_{out.1}(t), P_{out.2}(t), P_{out.3}(t), P_{out.4}(t)) of the set of output optical signals (S4) in response to different settings of the tunable frequency-to-amplitude conversion circuit (2), and
- an analyzing circuit (4) for determining the chirp characteristic (chirp(t)) by evaluating the optical intensities (PA(t), PB(t), PC(t) P_{out.1}(t), P_{out.2}(t), P_{out.3}(t), P_{out.4}(t)) detected by the optical detector (3),
wherein the tunable frequency-to-amplitude conversion circuit (2) comprises a dual path device (22) comprising a first and a second optical path having different optical path lengths for providing an interferometric superposition, and a polarization controller (21) adapted for providing the different settings by tuning a change of a state of polarization, and wherein the dual path device (22) and the polarization controller (21) are optically connected in series.

2. The optical test apparatus of claim 1, wherein the analyzing circuit (4) is adapted for deriving the chirp property from the detected intensities over time (PA(t), PB(t), PC(t) P_{out.1}(t), P_{out.2}(t), P_{out.3}(t), P_{out.4}(t)) and known parameters (C₁₁-C₄₄) of the polarization controller (21) relating to the different settings.

3. The optical test apparatus of claim 1 or 2, wherein the dual path device (22) comprises at least one polarization maintaining fiber, whereby the first and the second optical path represent the principal optical axes of the polarization maintaining fiber.

4. The optical test apparatus of claim 1 or 2, wherein the dual path device (22) comprises a polarization beam splitter (PBS1) adapted for polarization dependent splitting the incident light into the first and second optical path each of different lengths, and a polarization beam combiner (PBS2) adapted for combining the light received from both paths.

5. The optical test apparatus of claim 1 or any one of the above claims, wherein the polarization controller (21) is arranged to be located in front of the dual path device for receiving the input optical signal (S1) from the optical device (1) and to provide a set of polarization controlled signals (S2) to the dual path device (22).

6. The optical test apparatus of claim 1 or any one of the above claims 2-4, wherein the polarization controller (21) is arranged to be located behind the dual path device (22), whereby the dual path device (22) is adapted to receive the input optical signal (S1) from the optical device (1) and to provide a superimposed signal (S3') to the polarization controller (21).

7. The optical test apparatus of claim 1 or any one of the above claims, further comprising at least one polarizer (23), wherein the polarization controller (21), the dual path device (22) and the polarizer are optically connected in series.

8. The optical test apparatus of claim 1 or any one of the above claims, wherein the polarization controller (21) is adapted for converting the SOP to three states, such that the mean intensity of a corresponding first output signal equals the mean intensity of the input signal (S1) and the mean intensity of a second and third output signal (S4) equally half the mean intensity of the input signal (S1).

9. The optical test apparatus of claim 1 or any one of the above claims 1-7, wherein the polarization controller (21) is adapted for converting the SOP to four tetragonal polarization states.

10. The optical test apparatus of claim 1 or any one of the above claims 1-8 wherein different settings polarization controller (21) are selected such, that the corresponding polarization states are substantially achromatic within the substantial spectral range of the input optical signal (S1), whereby preferably a volume variation of a body spanned by the states of polarization set by the polarization controller is below of 10% within a wavelength range between 1250 nm and 1650 nm.

11. A method of determining an optical property of an optical device (1), comprising:
a) receiving an input optical signal (S1) from the optical device (1) and generating an output optical signal (S4) by performing in any order:
- changing a SOP by means of a polarization controller (21) operating at a first setting, and
- splitting into two partial signals and providing an interferometric superposition of both signals,
b) determining an optical intensity (PA(t), PB(t), PC(t) P_{out.1}(t), P_{out.2}(t), P_{out.3}(t), P_{out.4}(t)) of the output optical signal (S4),
c) controlling the polarization controller (21) to operate at a second setting in order to provide a different change of the SOP and repeating steps a) and b), and
d) determining the chirp characteristic by evaluating the optical intensities (PA(t), PB(t), PC(t) P_{out.1}(t), P_{out.2}(t), P_{out.3}(t), P_{out.4}(t)) determined in response to the different polarization controller settings.

12. A software program or product preferably stored on a data carrier, for executing the above method claim, when run on a data processing system.
